# EUROPEAN PATENT APPLICATION

(11) **EP 4 835 956 A1**
(43) Date of publication of application: **04.11.2026**
(21) Application number: 24912998.2
(22) Date of filing: 26.12.2024
(51) Int. Cl.: H01L 21/304, C11D 7/26, C11D 7/32

(54) **CLEANING AGENT COMPOSITION FOR FLUX RESIDUE REMOVAL**

(30) Priority: 28.12.2023 JP 2023223279; 25.12.2024 JP 2024229062
(71) Applicant: Kao Corporation, Tokyo 103-8210 (JP)
(72) Inventor: TERUYA, Yuta, Chuo-ku, Tokyo 103-8210 (JP); NAGANUMA, Jun, Chuo-ku, Tokyo 103-8210 (JP)
(74) Representative: Hoffmann Eitle
(86) International application number: PCT/JP2024/046140
(87) International publication number: WO 2025/143112

(57) **Abstract**

In one aspect, provided is a cleaning agent composition for removing flux residue that has good ability to remove both discolored metal and flux residue after a heat treatment at 200°C or more.

An aspect of the present disclosure relates to a cleaning agent composition for removing flux residue. The cleaning agent composition contains at least one organic solvent (component A) selected from the group consisting of a compound represented by the following formula (I) and a compound represented by the following formula (II), an imidazole compound (component B) represented by the following formula (III), a carboxylic acid (component C), and water (component D).

R¹-O-(AO)ₙ-R² (I)

R³-CH₂OH (II)

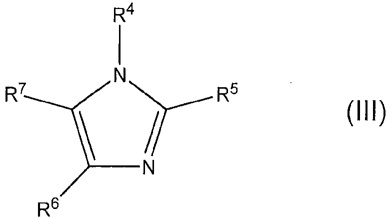

## Description

### Technical Field

The present disclosure relates to a cleaning agent composition for removing flux residue, and a cleaning method using the cleaning agent composition.

### Background Art

Electrodes used for circuits on electronic substrates of, e.g., semiconductor packages are made of metals such as copper and copper alloys in order to reduce production costs.

Surface mounting with improved packaging density is widely adopted as a method for mounting printed wiring boards. To increase the packaging density, there is a known technique that includes applying a nanometal paste between wiring on a substrate and terminals of an electronic element, melting and solidifying the applied nanometal by heating, and bonding the wiring and the terminals together.

On the other hand, a technique for cleaning solder flux from electronic components after soldering is known.

For example, WO 2020/116524 (Patent Document 1) proposes a cleaning agent composition for removing flux residue. The cleaning agent composition contains a solvent, an amine having a polar term δp of 7.8 or less in the Hansen solubility parameter, and a specific diphosphonic acid.

WO 2020/116534 (Patent Document 2) proposes a cleaning method that includes cleaning an object having flux residue with a cleaning agent composition. The cleaning agent composition contains an organic solvent and a compound having an alkyl group with 1 to 4 carbon atoms on a nitrogen atom of an imidazole ring or a piperazine ring.

JP H7 (1995)-179893 (Patent Document 3) proposes a cleaning agent composition that contains N-methyl-2-pyrrolidone containing 0 to 30% by weight of water and at least one compound selected from compounds of phosphines, phenols, imidazolidones, imidazoles, or fluorenes.

JP 2015-203047 (Patent Document 4) proposes a cleaning composition liquid for cleaning a semiconductor device substrate that has Cu wiring and an insulating film with a low dielectric constant on the substrate surface and has been subjected to chemical mechanical polishing. The cleaning composition liquid has a pH of 8 or more and contains the following: a tetramethylammonium hydroxide; diamines selected from ethylenediamine and 1,2-diaminopropane; organic acids selected from oxalic acid, citric acid, tartaric acid, malic acid, and picolinic acid; histidine or derivatives thereof; at least one selected from benzotriazole, imidazole, triazole, tetrazole, and derivatives thereof; and water.

JP 2023-14099 (Patent Document 5) proposes a cleaning composition that contains about 0.5 to 20% by weight of hydroxylamine, about 0.01 to 1% by weight of a chelating agent containing at least two nitrogen-containing groups, alkylene glycol, and water. The cleaning composition has a pH of about 7.5 to 11 and is configured to remove residues from a semiconductor substrate. The semiconductor substrate includes an interconnect containing cobalt.

JP 2021-102773 (Patent Document 6) proposes a cleaning composition that contains hydroxylamine, alkanolamine, alkylene glycol, and water. The cleaning composition has a pH of 7 to 11.

### Disclosure of the Invention

An aspect of the present disclosure relates to a cleaning agent composition for removing flux residue. The cleaning agent composition contains at least one organic solvent (component A) selected from the group consisting of a compound represented by the following formula (I) and a compound represented by the following formula (II), an imidazole compound (component B) represented by the following formula (III), a carboxylic acid (component C), and water (component D):

R¹-O-(AO)ₙ-R² (I),

in the formula (I), R¹ represents a phenyl group or an alkyl group having 1 to 8 carbon atoms, R² represents a hydrogen atom or an alkyl group having 1 to 4 carbon atoms, AO represents an ethylene oxide group or a propylene oxide group, and n represents the number of moles of AO added and is an integer of 1 or more and 3 or less;

R³-CH₂OH (II),

in the formula (II), R³ represents a phenyl group, a benzyl group, a cyclohexyl group, a furyl group, a tetrahydrofuryl group, a furfuryl group, or a tetrahydrofurfuryl group; 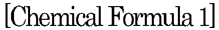 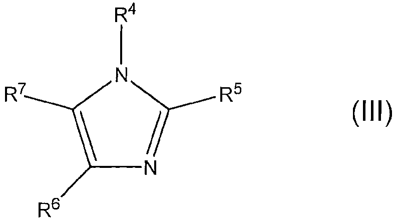 in the formula (III), R⁴, R⁵, R⁶, and R⁷ each independently represent a hydrogen atom, a halogen atom, a methyl group, an ethyl group, a propyl group, an isopropyl group, a butyl group, an isobutyl group, a phenyl group, an aldehyde group, a carboxy group, an aminoethyl group, an aminopropyl group, an acetyl group, a hydroxyethyl group, or a hydroxypropyl group.

An aspect of the present disclosure relates to a cleaning method that includes a cleaning process of cleaning a workpiece having flux residue with the cleaning agent composition for removing flux residue of the present disclosure. The workpiece is a substrate that has undergone a heating process at 200°C or more.

### Description of the Invention

When wiring on a substrate and terminals of an electronic element are bonded by applying a nanometal paste containing an acid (flux component) between them and melting and solidifying the applied nanometal by heating, a process of maintaining the substrate at a high temperature of 200°C or more is required to melt the metal. If flux residue composed mainly of the acid remains on the substrate after this process, the flux residue needs to be cleaned.

Depending on the type of metal of the substrate surface and metal members, the surface of the substrate may be oxidized and discolored while it is maintained at a high temperature of 200°C or more. Therefore, there is a demand for a cleaning agent composition that is able to remove the discolored portion, i.e., the oxidized metal (metal oxide) caused by the heat treatment at 200°C or more.

The present disclosure provides a cleaning agent composition for removing flux residue and a cleaning method, which are excellent in the removal of both discolored metal and flux residue after a heat treatment at 200°C or more.

The present inventors have found that the combination of at least one organic solvent (component A) selected from the group consisting of a compound represented by the formula (I) and a compound represented by the formula (II), an imidazole compound (component B) represented by the formula (III), a carboxylic acid (component C), and water (component D) can improve the removal of both discolored metal (metal oxide) and flux residue after a heat treatment at 200°C or more. Moreover, the present inventors have found that the use of a carboxylic acid having 8 or more carbon atoms as the component C can reduce damage to other members, including members of an apparatus (e.g., iron members such as a cleaning tank, cleaning pipes, and nozzles) and members provided on a substrate (e.g., iron members such as a cover).

In one aspect, the present disclosure relates to a cleaning agent composition for removing flux residue that remains after two members are joined by a sintering process. The cleaning agent composition for removing flux residue (also referred to as a "cleaning agent composition of the present disclosure" below) contains at least one organic solvent (component A) selected from the group consisting of a compound represented by the formula (I) and a compound represented by the formula (II), an imidazole compound (component B) represented by the formula (III), a carboxylic acid (component C), and water (component D).

The present disclosure can provide a cleaning agent composition for removing flux residue, which has good ability to remove both discolored metal (metal oxide) and flux residue after a heat treatment at 200°C or more. In one or more embodiments, the present disclosure can also provide a cleaning agent composition for removing flux residue, which further reduces damage to other members, e.g., iron members.

The details of the mechanism of the effects of the present disclosure are not fully clear, but can be assumed as follows.

In the cleaning agent composition of the present disclosure, a specific imidazole compound (component B) is adsorbed on the discolored metal (e.g., a metal oxide such as copper oxide) and forms an imidazole compound metal complex (e.g., an imidazole compound copper complex). Complexes, including the imidazole compound copper complex, have a low affinity for common organic solvents and do not easily diffuse from the surface of the metal oxide such as copper oxide. Consequently, the metal oxide cannot be removed completely. However, in the present disclosure, complexes, including the imidazole compound copper complex, are solvated with the specific organic solvent (component A) to form clusters with a high affinity. This facilitates the diffusion of the complexes into the specific organic solvent (component A). Such an effect may promote the dissolution reaction of the metal oxide, and thus allows the metal oxide to be removed completely. For the removal of flux residue, the neutralization reaction between the rosin acid contained in the flux residue and the imidazole compound may enhance the solubility of the flux residue.

Further, the cleaning agent composition of the present disclosure forms a carboxylic acid-imidazole compound composite due to the presence of the carboxylic acid (component C). Since the carboxylic acid-imidazole compound composite can increase the solvent versatility and facilitate the diffusion, the removal of the metal oxide can be accelerated. The use of the carboxylic acid having 8 or more carbon atoms enables selective adsorption on metal species, thereby reducing damage to other members.

In the present disclosure, the specific organic solvent (component A) is used in the presence of the specific imidazole compound (component B) and the carboxylic acid (component C). This configuration can further improve the solubility of the flux residue, and thus can effectively clean (remove) the flux residue.

As described above, the cleaning agent composition of the present disclosure may have good ability to remove both flux residue and discolored metal (metal oxide). The cleaning agent composition of the present disclosure may also reduce damage to other members, including members of an apparatus (e.g., iron members such as a cleaning tank, cleaning pipes, and nozzles) and members provided on a substrate (e.g., iron members such as a cover).

However, the present disclosure should not be interpreted solely by the above mechanism.

The term "flux" in the present disclosure means, in one or more embodiments, flux that is used to join two members by a sintering process (e.g., a process of maintaining the members at a high temperature of 200°C or more). For example, the flux is used to join a heat sink and a semiconductor device or to join a heat sink and a substrate. In one or more embodiments, the flux is an acid-based bonding aid.

The term "flux residue" in the present disclosure means a residue derived from the flux that remains on, e.g., a substrate after solder bumps are formed thereon using flux and/or a substrate after soldering is performed thereon using flux. For example, when other components (such as semiconductor chips, chip capacitors, and other circuit boards) are mounted on a circuit board in layers, a space (gap) is created between the circuit board and the other components. The flux used for the mounting can also remain in the gap as flux residue after reflow soldering or the like.

The term "cleaning agent composition for removing flux residue" in the present disclosure means, in one or more embodiments, a cleaning agent composition for removing flux residue that remains after two members are joined by a sintering process.

### [Component A: organic solvent]

The cleaning agent composition of the present disclosure contains at least one organic solvent (also referred to as a "component A" below) selected from the group consisting of a compound represented by the following formula (I) and a compound represented by the following formula (II). The organic solvent may be one type or a combination of two or more types.

### <Compound represented by formula (I)>

R¹-O-(AO)ₙ-R² (I)

In the formula (I), R¹ represents a phenyl group or an alkyl group having 1 to 8 carbon atoms. From the viewpoint of improving the flux residue removal performance, R¹ is preferably a phenyl group or an alkyl group having 4 to 6 carbon atoms, and more preferably an alkyl group having 4 to 6 carbon atoms.

R² represents a hydrogen atom or an alkyl group having 1 to 4 carbon atoms, and is preferably a hydrogen atom from the viewpoint of ease of rinsing. Moreover, R² is preferably an alkyl group having 2 to 4 carbon atoms, and more preferably an n-butyl group from the viewpoint of improving the flux residue removal performance.

AO represents an ethyleneoxy group (EO) or a propyleneoxy group (PO). From the same viewpoint, AO is preferably an ethyleneoxy group.

In the formula (I), n represents the number of moles of AO added and is an integer of 1 or more and 3 or less. From the same viewpoint, n is preferably 1 or 2, and more preferably 2.

Examples of the compound represented by the formula (I) include the following: monophenyl glycol ethers, e.g., ethylene glycol monophenyl ether (PHG-S, 2-phenoxyethanol), diethylene glycol monophenyl ether, and propylene glycol monophenyl ether; monobenzyl glycol ethers, e.g., ethylene glycol monobenzyl ether, diethylene glycol monobenzyl ether, and propylene glycol monobenzyl ether; monoalkyl ethers, e.g., ethylene glycol monoalkyl ether having an alkyl group with 1 to 8 carbon atoms, diethylene glycol monoalkyl ether, and triethylene glycol monoalkyl ether; dialkyl ethers, e.g., ethylene glycol dialkyl ether having an alkyl group with 1 to 8 carbon atoms and an alkyl group with 1 to 4 carbon atoms, diethylene glycol dialkyl ether, and triethylene glycol dialkyl ether; and phenyl alkyl ethers, e.g., ethylene glycol phenyl alkyl ether having a phenyl group and an alkyl group with 1 to 4 carbon atoms, diethylene glycol phenyl alkyl ether, and triethylene glycol phenyl alkyl ether. Among these, from the viewpoint of improving the flux residue removal performance, the compound represented by the formula (I) is preferably at least one selected from the group consisting of ethylene glycol monophenyl ether (PHG-S), diethylene glycol monobutyl ether (BDG), dipropylene glycol monobutyl ether (BFDG), diethylene glycol dibutyl ether (DBDG), and diethylene glycol diethyl ether, and more preferably diethylene glycol monobutyl ether (BDG).

### <Compound represented by formula (II)>

R³-CH₂OH (II)

In the formula (II), R³ represents a phenyl group, a benzyl group, a cyclohexyl group, a furyl group, a tetrahydrofuryl group, a furfuryl group, or a tetrahydrofurfuryl group. From the viewpoint of improving the flux residue removal performance, R³ is preferably a phenyl group, a cyclohexyl group, or a tetrahydrofuryl group, and more preferably a phenyl group or a tetrahydrofuryl group.

The compound represented by the formula (II) may be, e.g., at least one selected from the group consisting of benzyl alcohol, phenethyl alcohol, cyclohexanemethanol, furfuryl alcohol, and tetrahydrofurfuryl alcohol. From the viewpoint of improving the flux residue removal performance, the compound represented by the formula (II) is preferably at least one selected from the group consisting of benzyl alcohol, furfuryl alcohol, and tetrahydrofurfuryl alcohol, and more preferably at least one selected from the group consisting of benzyl alcohol (BzOH) and tetrahydrofurfuryl alcohol.

In the present disclosure, the content of the component A in the cleaning agent composition at the time of use is preferably 10% by mass or more, more preferably 20% by mass or more, even more preferably more than 25% by mass, and still more preferably 40% by mass or more from the viewpoint of improving the discolored metal removal performance. The content of the component A in the cleaning agent composition at the time of use is preferably 90% by mass or less, more preferably 85% by mass or less, and even more preferably 80% by mass or less from the viewpoint of improving the metal dissolving capability of the component B. More specifically, the content of the component A in the cleaning agent composition at the time of use is preferably 10% by mass or more and 90% by mass or less, more preferably 20% by mass or more and 85% by mass or less, even more preferably more than 25% by mass and 80% by mass or less, and still more preferably 40% by mass or more and 80% by mass or less. When the component A is a combination of two or more types, the content of the component A is the total content of the two or more types.

### [Component B: imidazole compound represented by formula (III)]

The cleaning agent composition of the present disclosure contains an imidazole compound (also referred to as a "component B" below) represented by the following formula (III). The imidazole compound may be one type or a combination of two or more types.

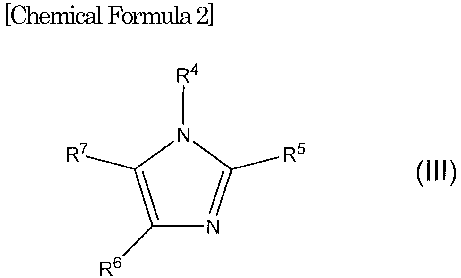

In the formula (III), R⁴, R⁵, R⁶, and R⁷ each independently represent a hydrogen atom, a halogen atom, a methyl group, an ethyl group, a propyl group, an isopropyl group, a butyl group, an isobutyl group, a phenyl group, an aldehyde group, a carboxy group, an aminoethyl group, an aminopropyl group, an acetyl group, a hydroxyethyl group, or a hydroxypropyl group.

From the viewpoint of improving the discolored metal removal performance, R⁴, R⁵, R⁶, and R⁷ in the formula (III) each independently represent preferably a hydrogen atom, a methyl group, an ethyl group, a propyl group, an isopropyl group, a butyl group, an isobutyl group, a phenyl group, an aminoethyl group, an aminopropyl group, an acetyl group, a hydroxyethyl group, or a hydroxypropyl group, more preferably a methyl group, an ethyl group, a propyl group, an isopropyl group, a butyl group, an isobutyl group, or a hydroxyethyl group, and even more preferably a methyl group or an ethyl group.

From the viewpoint of improving both the discolored metal removal performance and the flux residue removal performance, the component B may be, e.g., at least one selected from the group consisting of imidazole, 1-methylimidazole, 1-ethylimidazole, 1-propylimidazole, 1-isopropylimidazole, 1-acetylimidazole, 1-aminopropylimidazole, 1-hydroxyethylimidazole, 2-methylimidazole, 2-ethylimidazole, 2-propylimidazole, 2-isopropylimidazole, 2-acetylimidazole, 2-aminopropylimidazole, 2-hydroxyethylimidazole, 4-methylimidazole, 4-ethylimidazole, 4-propylimidazole, 4-isopropylimidazole, 4-acetylimidazole, 4-aminopropylimidazole, 4-hydroxyethylimidazole, 1,2-dimethylimidazole, 1-isobutyl-2-methylimidazole, and 2-ethyl-4-methylimidazole. Among these, from the same viewpoint, the component B is preferably at least one selected from the group consisting of 1-methylimidazole, 2-methylimidazole, 1-isobutyl-2-methylimidazole, and 2-ethyl-4-methylimidazole.

In the present disclosure, the content of the component B in the cleaning agent composition at the time of use is preferably 0.5% by mass or more, more preferably 0.75% by mass or more, and even more preferably 1% by mass or more from the viewpoint of improving both the discolored metal removal performance and the flux residue removal performance. From the same viewpoint, the content of the component B in the cleaning agent composition at the time of use is preferably 15% by mass or less, more preferably 10% by mass or less, and even more preferably 8% by mass or less. More specifically, the content of the component B in the cleaning agent composition at the time of use is preferably 0.5% by mass or more and 15% by mass or less, more preferably 0.75% by mass or more and 10% by mass or less, and even more preferably 1% by mass or more and 10% by mass or less. More specifically, the content of the component B in the cleaning agent composition at the time of use is still more preferably 0.75% by mass or more and 8% by mass or less, and yet more preferably 1% by mass or more and 8% by mass or less. When the component B is a combination of two or more types, the content of the component B is the total content of the two or more types.

In the cleaning agent composition of the present disclosure, the mass ratio (B/A) of the component B to the component A (the content (% by mass) of the component B / the content (% by mass) of the component A) is preferably 0.005 or more, more preferably 0.008 or more, even more preferably 0.01 or more, still more preferably 0.03 or more, and yet more preferably 0.05 or more from the viewpoint of improving the discolored metal removal performance. From the same viewpoint, the mass ratio (B/A) is preferably 1.0 or less, more preferably 0.5 or less, even more preferably 0.3 or less, still more preferably 0.2 or less, and yet more preferably 0.1 or less. More specifically, the mass ratio (B/A) is preferably 0.005 or more and 1.0 or less, more preferably 0.008 or more and 0.5 or less, and even more preferably 0.01 or more and 0.3 or less, 0.03 or more and 0.2 or less, or 0.01 or more and 0.1 or less.

### [Component C: carboxylic acid]

The cleaning agent composition of the present disclosure contains a carboxylic acid (also referred to as a "component C" below). The carboxylic acid may be one type or a combination of two or more types.

The carbon number of the component C is preferably 2 or more from the viewpoint of improving both the discolored metal removal performance and the flux residue removal performance, and is preferably 8 or more from the viewpoint of reducing damage to other members, e.g., iron members. Furthermore, the carbon number of the component C is preferably 22 or less, more preferably 18 or less, and even more preferably 16 or less from the viewpoint of improving both the discolored metal removal performance and the flux residue removal performance and from the viewpoint of reducing damage to other members, e.g., iron members. More specifically, the carbon number of the component C is preferably 2 or more and 22 or less or 8 or more and 22 or less, more preferably 8 or more and 18 or less, and even more preferably 8 or more and 16 or less.

The component C is preferably a carboxylic acid having 8 or more carbon atoms from the viewpoint of improving both the discolored metal removal performance and the flux residue removal performance and from the viewpoint of reducing damage to other members, e.g., iron members. The component C may be, e.g., at least one selected from the group consisting of caprylic acid, capric acid, dodecanedioic acid, lauric acid, myristic acid, palmitic acid, oleic acid, stearic acid, and behenic acid.

In the present disclosure, the content of the component C in the cleaning agent composition at the time of use is preferably 0.5% by mass or more, and more preferably 3.5% by mass or more from the viewpoint of improving both the discolored metal removal performance and the flux residue removal performance. From the same viewpoint, the content of the component C in the cleaning agent composition at the time of use is preferably 10% by mass or less, and more preferably 5% by mass or less. More specifically, the content of the component C in the cleaning agent composition at the time of use is preferably 0.5% by mass or more and 10% by mass or less, and more preferably 3.5% by mass or more and 5% by mass or less. When the component C is a combination of two or more types, the content of the component C is the total content of the two or more types.

In the cleaning agent composition of the present disclosure, the mass ratio (C/A) of the component C to the component A (the content (% by mass) of the component C / the content (% by mass) of the component A) is preferably 0.0001 or more, more preferably 0.005 or more, and even more preferably 0.01 or more from the viewpoint of improving the discolored metal removal performance. From the same viewpoint, the mass ratio (C/A) is preferably 1.0 or less, more preferably 0.5 or less, even more preferably 0.1 or less, and still more preferably 0.05 or less. More specifically, the mass ratio (C/A) is preferably 0.0001 or more and 1.0 or less, more preferably 0.005 or more and 0.5 or less, even more preferably 0.01 or more and 0.1 or less, and still more preferably 0.01 or more and 0.05 or less.

In the cleaning agent composition of the present disclosure, the mass ratio (B/C) of the component B to the component C (the content (% by mass) of the component B / the content (% by mass) of the component C) is preferably 0.01 or more, more preferably 0.1 or more, and even more preferably 0.5 or more from the viewpoint of improving the discolored metal removal performance. From the same viewpoint, the mass ratio (B/C) is preferably 25 or less, more preferably 15 or less, even more preferably 5 or less, and still more preferably 2 or less. More specifically, the mass ratio (B/C) is preferably 0.01 or more and 25 or less, more preferably 0.1 or more and 15 or less, and even more preferably 0.5 or more and 5 or less.

### [Component D: water]

The cleaning agent composition of the present disclosure contains water (also referred to as a "component D" below). Examples of the water include ion-exchanged water, RO water (reverse osmosis membrane treated water), distilled water, pure water, and ultrapure water.

In the present disclosure, the content of the component D in the cleaning agent composition at the time of use is preferably 0.5% by mass or more, and more preferably 5% by mass or more from the viewpoint of improving the discolored metal removal performance. Furthermore, the content of the component D in the cleaning agent composition at the time of use is preferably 20% by mass or less, and more preferably 10% by mass or less from the viewpoint of improving both the discolored metal removal performance and the flux residue removal performance. More specifically, the content of the component D in the cleaning agent composition at the time of use is preferably 0.5% by mass or more and 20% by mass or less, and more preferably 5% by mass or more and 10% by mass or less.

### [Component E: amine represented by formula (IV)]

In one or more embodiments, the cleaning agent composition of the present disclosure may further contain an amine (also referred to as a "component E" below) represented by the following formula (IV). The component E may be one type or a combination of two or more types.

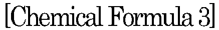

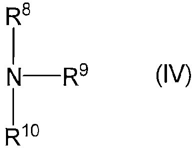

In the formula (IV), R⁸ represents a hydrogen atom, an alkyl group, a phenyl group, a benzyl group, a hydroxyethyl group, a hydroxypropyl group, or an aminoethyl group, R⁹ represents a hydrogen atom, a hydroxyethyl group, a hydroxypropyl group, or an alkyl group, and R¹⁰ represents a hydroxyethyl group, a hydroxypropyl group, or an alkyl group. The alkyl group may be, e.g., an alkyl group having 1 to 6 carbon atoms from the viewpoint of improving both the discolored metal removal performance and the flux residue removal performance.

The component E may be, e.g., at least one selected from the group consisting of alkanolamines and aromatic amines. Examples of the alkanolamines include monoethanolamine (MEA), monoisopropanolamine, N-methylmonoethanolamine, N-methylisopropanolamine, N-ethylmonoethanolamine, N-ethylisopropanolamine, diethanolamine, diisopropanolamine, N-dimethylmonoethanolamine, N-dimethylmonoisopropanolamine, N-methyldiethanolamine, N-methyldiisopropanolamine, N-diethylmonoethanolamine, N-diethylmonoisopropanolamine, N-ethyldiethanolamine, N-ethyldiisopropanolamine, N-(β-aminoethyl)ethanolamine, N-(β-aminoethyl)isopropanolamine, N-(β-aminoethyl)diethanolamine, N-(β-aminoethyl)diisopropanolamine, and N,N-dibutylethanolamine (dibutylaminoethanol). Examples of the aromatic amines include dimethylbenzylamine. Among these, from the viewpoint of improving both the discolored metal removal performance and the flux residue removal performance, the component E is preferably at least one selected from the group consisting of diisopropanolamine and N,N-dibutylethanolamine (dibutylaminoethanol).

When the cleaning agent composition of the present disclosure contains the component E, the content of the component E in the cleaning agent composition at the time of use is preferably 0.2% by mass or more, more preferably 0.5% by mass or more, and even more preferably 1% by mass or more from the viewpoint of improving the flux residue removal performance. From the same viewpoint, the content of the component E in the cleaning agent composition at the time of use is preferably 15% by mass or less, more preferably 10% by mass or less, and even more preferably 5% by mass or less. More specifically, the content of the component E in the cleaning agent composition at the time of use is preferably 0.2% by mass or more and 15% by mass or less, more preferably 0.5% by mass or more and 10% by mass or less, and even more preferably 1% by mass or more and 5% by mass or less. When the component E is a combination of two or more types, the content of the component E is the total content of the two or more types.

### [Other components]

The cleaning agent composition of the present disclosure may contain, as appropriate, at least one selected from the following components typically used for cleaning agents, as long as they do not interfere with the effects of the present disclosure: organic solvents other than the component A; basic substances other than the component B; fatty acids other than component C; chelating agents; anticorrosive agents; thickening agents; dispersing agents; pH adjusters; polymer compounds; surfactants; solubilizers; preservatives; bactericides; antibacterial agents; antifoaming agents; and antioxidants.

In one or more embodiments, the cleaning agent composition of the present disclosure may contain substantially no diphosphonic acid. For example, the content of the diphosphonic acid in the cleaning agent composition at the time of use is preferably less than 0.1% by mass, more preferably 0.01% by mass or less, and even more preferably 0% by mass (i.e., no diphosphonic acid is contained).

### [Production method of cleaning agent composition]

The cleaning agent composition of the present disclosure can be produced by blending, e.g., the component A, the component B, the component C, and the component D, and optional components (the component E and other components) as desired, with a known method. In one or more embodiments, the cleaning agent composition of the present disclosure can be produced by blending at least the component A, the component B, the component C, and the component D. Thus, in one aspect, the present disclosure relates to a method for producing a cleaning agent composition that includes blending at least the component A, the component B, the component C, and the component D. In the present disclosure, the term "blend" may include mixing the component A, the component B, the component C, and the component D, and the optional components (the component E and other components) as desired, simultaneously or in any order.

The blending amount of each component in the production method of the cleaning agent composition of the present disclosure may be the same as the content of each component in the cleaning agent composition at the time of use, as described above.

In the present disclosure, the "content of each component in the cleaning agent composition at the time of use" means the amount of each component at the time of cleaning, i.e., at the time the cleaning agent composition starts to be used for cleaning.

### [pH of cleaning agent composition]

The pH of the cleaning agent composition of the present disclosure is preferably 5 or more, and more preferably 6 or more from the viewpoint of improving both the discolored metal removal performance and the flux residue removal performance. From the same viewpoint, the pH of the cleaning agent composition is preferably 12 or less, more preferably 11 or less, and even more preferably 10 or less. More specifically, the pH of the cleaning agent composition is preferably 5 or more and 12 or less, more preferably 6 or more and 11 or less, and even more preferably 6 or more and 10 or less. The pH can be adjusted, as appropriate, by using inorganic acids, e.g., nitric acid and sulfuric acid, organic acids, e.g., oxycarboxylic acid, polycarboxylic acid, aminopolycarboxylic acid, and amino acid, metal salts or ammonium salts of these inorganic and organic acids, ammonia, sodium hydroxide, potassium hydroxide, amines, or carboxylic acid (component C). In the present disclosure, the pH of the cleaning agent composition is a value at a temperature of 25°C when used. Specifically, the pH of the cleaning agent composition can be measured by a method as described in Examples.

In one or more embodiments, the cleaning agent composition of the present disclosure is used to clean a workpiece having flux residue, particularly a workpiece having flux residue that remains after two members are joined by a sintering process.

In one or more embodiments, the cleaning agent composition of the present disclosure may be used as a cleaning agent to remove flux residue from a workpiece having flux residue. Thus, in one aspect, the present disclosure relates to use of the cleaning agent composition containing the component A, the component B, the component C, and the component D (i.e., the cleaning agent composition of the present disclosure) as a flux residue cleaning agent.

In one or more other embodiments, the cleaning agent composition of the present disclosure may be used as a removing agent to remove flux residue from a workpiece having flux residue. Thus, in another aspect, the present disclosure relates to use of the cleaning agent composition of the present disclosure as a flux residue removing agent.

### [Workpiece]

In one or more embodiments, a workpiece (also referred to as an object to be cleaned) may be, e.g., a substrate that has undergone a heating process at 200°C or more. In one or more embodiments, the workpiece may have a metal member containing copper on the substrate. In one or more embodiments, the heating process at 200°C or more indicates a process (sintering process) of maintaining the substrate at a high temperature of 200°C or more.

In one or more embodiments, the workpiece may be, e.g., a workpiece having flux residue (also referred to as an object to be cleaned having flux residue). In one or more embodiments, the workpiece having flux residue may be, e.g., a substrate having flux residue, which has been subjected to the process of applying a flux-containing slurry between the substrate and a metal member or between two metal members on the substrate and heating them at 200°C or more (sintering process). Thus, in one aspect, the present disclosure relates to use of the cleaning agent composition of the present disclosure to clean a substrate having flux residue, which has been subjected to the process of applying a flux-containing slurry between the substrate and a metal member or between two metal members on the substrate and heating them at 200°C or more (sintering process).

In the sintering process, the heating temperature may be, e.g., 200°C to 350°C. The heating time may be, e.g., 3 minutes to 5 hours. From the viewpoint of ensuring the ability to clean thermally degraded flux, it is preferable that the workpiece has been heated for at least 1 hour.

In one or more embodiments, the substrate surface and/or the metal member of the workpiece includes a portion in which the metal has been discolored by heating, i.e., a portion in which the metal has been oxidized (metal oxide).

In one or more embodiments, the flux contains an acid as the main component. Examples of the acid include organic acids, e.g., abietic acid.

In one or more embodiments, the flux-containing slurry may further contain metal particles. The metal particles preferably have a sintering temperature (curing temperature) of 300°C or less. The metal particles may be composed of, e.g., tin, copper, silver, or a mixture thereof, preferably composed of copper, silver, or a mixture thereof, and more preferably composed of silver. In one or more embodiments, the metal particles serve as a bonding material capable of bonding the substrate and a metal member or bonding two metal members on the substrate. In one or more embodiments, the flux-containing slurry may be used as a die attach paste. When the flux-containing slurry further contains metal particles, in one or more embodiments, the slurry can be used as a conductive die attach paste.

In one or more embodiments, the metal member is fixed on the substrate.

In one or more embodiments, the metal of the metal member includes, e.g., copper or iron. Examples of the metal member include a heat sink and an electric circuit.

In one or more embodiments, the substrate may be a substrate having a metal surface, including, e.g., a copper plate, a steel plate, and a stainless-steel plate.

In one or more embodiments, the substrate surface and/or the metal member of the workpiece contains copper.

### [Cleaning method]

In one aspect, the present disclosure relates to a cleaning method (also referred to as a "cleaning method of the present disclosure" below) that includes a cleaning process of cleaning a workpiece having flux residue with the cleaning agent composition of the present disclosure. Examples of the workpiece may be those as described above. In one or more embodiments, the cleaning process includes bringing the workpiece having flux residue into contact with the cleaning agent composition of the present disclosure. The cleaning method of the present disclosure can efficiently remove both discolored metal (metal oxide) and flux residue after a heat treatment at a high temperature of 200°C or more.

In one or more embodiments, the cleaning process includes removing the discolored metal with the cleaning agent composition of the present disclosure. Thus, in one aspect, the present disclosure relates to use of the cleaning agent composition of the present disclosure to remove the discolored metal and the flux residue. In one or more embodiments, the discolored metal includes a portion in which the metal has been oxidized by heating (metal oxide).

Cleaning the workpiece with the cleaning agent composition of the present disclosure or bringing the workpiece into contact with the cleaning agent composition of the present disclosure may be performed in the following manner. For example, the workpiece may be immersed in the cleaning agent composition placed in a bath of an ultrasonic cleaning apparatus, or the cleaning agent composition may be sprayed onto the workpiece (i.e., a shower method). In one or more embodiments, the cleaning agent composition of the present disclosure can be used for cleaning directly without dilution.

In one or more embodiments, the cleaning process includes immersing the workpiece in the cleaning agent composition of the present disclosure. The immersion temperature is preferably 20°C or more, more preferably 30°C or more, and even more preferably 40°C or more from the viewpoint of improving both the discolored metal removal performance and the flux residue removal performance. Furthermore, the immersion temperature is preferably 80°C or less, more preferably 70°C or less, and even more preferably 60°C or less from the viewpoint of safety of handling and reducing the load on the apparatus. From the same viewpoint, the immersion time is preferably 5 minutes or more, more preferably 10 minutes or more, and even more preferably 30 minutes or more, and is also preferably 3 hours or less, more preferably 2 hours or less, and even more preferably 1 hour or less.

In one or more embodiments, the cleaning method of the present disclosure preferably includes rinsing the workpiece with water and/or alcohol (e.g., methanol) after the workpiece has been in contact with the cleaning agent composition, and drying the rinsed workpiece.

The cleaning method of the present disclosure preferably includes irradiating the workpiece with ultrasonic waves when the workpiece comes into contact with the cleaning agent composition of the present disclosure, and more preferably uses the ultrasonic waves of relatively high intensity. This can help to enhance the cleaning power of the cleaning agent composition.

In one or more other embodiments, the cleaning process in the cleaning method of the present disclosure is a process (removing process) of cleaning and removing flux residue from a workpiece with a flux residue removing agent. The flux residue removing agent used in the removing process may be, e.g., the flux residue cleaning and removing composition of the present disclosure.

In one or more embodiments, the cleaning method of the present disclosure is a flux residue cleaning and removing method that includes cleaning and removing flux residue from a workpiece with the flux residue cleaning and removing composition of the present disclosure. The workpiece is a substrate that has undergone a heating process (sintering process) at 200°C or more and has flux residue.

### [Production method of electronic component]

In one aspect, the present disclosure relates to a method for producing an electronic component by using the cleaning method of the present disclosure (also referred to as a "production method of an electronic component of the present disclosure" below).

In one or more embodiments, the production method of an electronic component of the present disclosure includes a cleaning process of cleaning a substrate (workpiece) having flux residue with the cleaning agent composition or the cleaning method of the present disclosure, where the substrate having flux residue has been subjected to the process of applying a flux-containing slurry between the substrate and a metal member or between two metal members on the substrate and heating them at 200°C or more (sintering process).

In one or more embodiments, the cleaning process includes bringing the workpiece having flux residue into contact with the cleaning agent composition of the present disclosure. The cleaning method in the cleaning process may be the same as the cleaning method of the present disclosure. Examples of the workpiece may be those as described above.

The present disclosure further relates to one or more embodiments as follows.
<1> A cleaning agent composition for removing flux residue, comprising:
   at least one organic solvent (component A) selected from the group consisting of a compound represented by the following formula (I) and a compound represented by the following formula (II);
   an imidazole compound (component B) represented by the following formula (III);
   a carboxylic acid (component C); and
   water (component D),

      R¹-O-(AO)ₙ-R² (I),
   in the formula (I), R¹ represents a phenyl group or an alkyl group having 1 to 8 carbon atoms, R² represents a hydrogen atom or an alkyl group having 1 to 4 carbon atoms, AO represents an ethylene oxide group or a propylene oxide group, and n represents a number of moles of AO added and is an integer of 1 or more and 3 or less,

      R³-CH₂OH (II),
   in the formula (II), R³ represents a phenyl group, a benzyl group, a cyclohexyl group, a furyl group, a tetrahydrofuryl group, a furfuryl group, or a tetrahydrofurfuryl group, 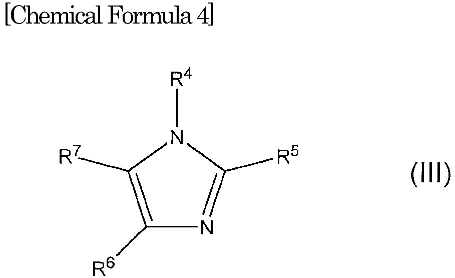
   in the formula (III), R⁴, R⁵, R⁶, and R⁷ each independently represent a hydrogen atom, a halogen atom, a methyl group, an ethyl group, a propyl group, an isopropyl group, a butyl group, an isobutyl group, a phenyl group, an aldehyde group, a carboxy group, an aminoethyl group, an aminopropyl group, an acetyl group, a hydroxyethyl group, or a hydroxypropyl group.
<2> The cleaning agent composition according to <1>, wherein a content of the component A is 10% by mass or more and 90% by mass or less, 20% by mass or more and 85% by mass or less, more than 25% by mass and 80% by mass or less, or 40% by mass or more and 80% by mass or less.
<3> The cleaning agent composition according to <1> or <2>, wherein a content of the component B is 0.5% by mass or more and 15% by mass or less, 0.75% by mass or more and 8% by mass or less, or 1% by mass or more and 8% by mass or less.
<4> The cleaning agent composition according to any one of <1> to <3>, wherein the component B is at least one selected from the group consisting of imidazole, 1-methylimidazole, 1-ethylimidazole, 1-propylimidazole, 1-isopropylimidazole, 1-acetylimidazole, 1-aminopropylimidazole, 1-hydroxyethylimidazole, 2-methylimidazole, 2-ethylimidazole, 2-propylimidazole, 2-isopropylimidazole, 2-acetylimidazole, 2-aminopropylimidazole, 2-hydroxyethylimidazole, 4-methylimidazole, 4-ethylimidazole, 4-propylimidazole, 4-isopropylimidazole, 4-acetylimidazole, 4-aminopropylimidazole, 4-hydroxyethylimidazole, 1,2-dimethylimidazole, 1-isobutyl-2-methylimidazole, and 2-ethyl-4-methylimidazole.
<5> The cleaning agent composition according to any one of <1> to <4>, wherein the component B is at least one selected from the group consisting of 1-methylimidazole, 2-methylimidazole, 1-isobutyl-2-methylimidazole, and 2-ethyl-4-methylimidazole, and
   the content of the component A is 20% by mass or more and 85% by mass or less.
<6> The cleaning agent composition according to any one of <1> to <5>, wherein a content of the component C is 0.5% by mass or more and 10% by mass or less, or 3.5% by mass or more and 5% by mass or less.
<7> The cleaning agent composition according to any one of <1> to <6>, wherein a mass ratio (C/A) of the component C to the component A is 0.0001 or more and 1.0 or less, 0.005 or more and 0.5 or less, or 0.01 or more and 0.05 or less.
<8> The cleaning agent composition according to any one of <1> to <7>, wherein a mass ratio (B/A) of the component B to the component A is 0.005 or more and 1.0 or less, 0.008 or more and 0.5 or less, 0.01 or more and 0.3 or less, or 0.03 or more and 0.2 or less.
<9> The cleaning agent composition according to any one of <1> to <8>, wherein the component A is at least one selected from the group consisting of ethylene glycol monophenyl ether (PHG-S), diethylene glycol monobutyl ether (BDG), dipropylene glycol monobutyl ether (BFDG), diethylene glycol dibutyl ether (DBDG), and diethylene glycol diethyl ether,
   wherein the component B is at least one selected from the group consisting of 1-methylimidazole, 2-methylimidazole, 1-isobutyl-2-methylimidazole, and 2-ethyl-4-methylimidazole, and
   wherein the mass ratio (B/A) of the component B to the component A is 0.005 or more and 1.0 or less.
<10> The cleaning agent composition according to any one of <1> to <9>, wherein a mass ratio (B/C) of the component B to the component C is 0.01 or more and 25 or less, 0.1 or more and 15 or less, or 0.5 or more and 5 or less.
<11> The cleaning agent composition according to any one of <1> to <10>, wherein a content of the component D is 0.5% by mass or more and 20% by mass or less, or 5% by mass or more and 10% by mass or less.
<12> The cleaning agent composition according to any one of <1> to <11>, wherein the component C is a carboxylic acid having 8 or more carbon atoms.
<13> The cleaning agent composition according to any one of <1> to <12>, wherein the component C is at least one selected from the group consisting of caprylic acid, capric acid, dodecanedioic acid, lauric acid, myristic acid, palmitic acid, oleic acid, stearic acid, and behenic acid.
<14> The cleaning agent composition according to any one of <1> to <13>, wherein the component A is at least one selected from the group consisting of ethylene glycol monophenyl ether (PHG-S), diethylene glycol monobutyl ether (BDG), dipropylene glycol monobutyl ether (BFDG), diethylene glycol dibutyl ether (DBDG), and diethylene glycol diethyl ether,
   wherein the component C is at least one selected from the group consisting of caprylic acid, capric acid, dodecanedioic acid, lauric acid, myristic acid, palmitic acid, oleic acid, stearic acid, and behenic acid, and
   wherein the mass ratio (C/A) of the component C to the component A is 0.0001 or more and 1.0 or less.
<15> The cleaning agent composition according to any one of <1> to <14>, wherein the component B is at least one selected from the group consisting of 1-methylimidazole, 2-methylimidazole, 1-isobutyl-2-methylimidazole, and 2-ethyl-4-methylimidazole,
   wherein the component C is at least one selected from the group consisting of caprylic acid, capric acid, dodecanedioic acid, lauric acid, myristic acid, palmitic acid, oleic acid, stearic acid, and behenic acid, and
   wherein the mass ratio (B/C) of the component B to the component C is 0.01 or more and 25 or less.
<16> A cleaning method comprising: a cleaning process of cleaning a workpiece having flux residue with the cleaning agent composition according to any one of <1> to <15>,
   wherein the workpiece is a substrate that has undergone a heating process at 200°C or more.
<17> The cleaning method according to <16>, wherein the workpiece has a metal member containing copper on the substrate.
<18> The cleaning method according to <17>, wherein the substrate surface and/or the metal member of the workpiece includes a portion in which the metal has been oxidized.

### Examples

Hereinafter, the present disclosure will be described in detail by way of examples. However, the present disclosure is not limited to the following examples.

### 1. Preparation of cleaning agent composition (Examples 1 to 33, Comparative Examples 1 to 5)

Cleaning agent compositions of Examples 1 to 33 and Comparative Examples 1 to 5 were prepared by adding their respective components in the amounts shown in Tables 1-1, 1-2, and 2 into a 100 mL glass beaker and mixing them together under the following conditions. The value of each component in the tables indicates the content (% by mass) of each component in the cleaning agent composition prepared, unless otherwise specified.

### <Mixing conditions>

Liquid temperature: 60°C
Stirrer: magnetic stirrer (50 mm rotor)
Rotation speed: 300 rpm
Stirring time: 1 hour

The following components were used in the preparation of the cleaning agent compositions.

### (Component A)

2-phenoxyethanol (PHG-S) [ethylene glycol monophenyl ether, manufactured by Tokyo Chemical Industry Co., Ltd.]
Benzyl alcohol [manufactured by LANXESS K.K.]
Butyl carbitol solvent (BDG) [diethylene glycol monobutyl ether, manufactured by NIPPON NYUKAZAI CO., LTD.]
DBDG [diethylene glycol dibutyl ether, manufactured by NIPPON NYUKAZAI CO., LTD.]
BFDG [dipropylene glycol monobutyl ether, manufactured by NIPPON NYUKAZAI CO., LTD.]
Tetrahydrofurfuryl alcohol [manufactured by FUJIFILM Wako Pure Chemical Corporation]

### (Component B)

2-methylimidazole [manufactured by Tokyo Chemical Industry Co., Ltd.]
2-ethyl-4-methylimidazole [manufactured by FUJIFILM Wako Pure Chemical Corporation]
1-methylimidazole [manufactured by Tokyo Chemical Industry Co., Ltd.]
1-isobutyl-2-methylimidazole [manufactured by Tokyo Chemical Industry Co., Ltd.]

### (Component C)

Caprylic acid [carbon number 8, manufactured by Kao Corporation]
Capric acid [carbon number 10, manufactured by Kao Corporation]
Dodecanedioic acid [carbon number 12, manufactured by FUJIFILM Wako Pure Chemical Corporation]
Lauric acid [carbon number 12, manufactured by Kao Corporation]
Myristic acid [carbon number 14, manufactured by FUJIFILM Wako Pure Chemical Corporation]
Palmitic acid [carbon number 16, manufactured by FUJIFILM Wako Pure Chemical Corporation]
Oleic acid [carbon number 18, manufactured by FUJIFILM Wako Pure Chemical Corporation]
Stearic acid [carbon number 18, manufactured by FUJIFILM Wako Pure Chemical Corporation]
Behenic acid [carbon number 22, manufactured by Kao Corporation]
Lactic acid [carbon number 2, manufactured by FUJIFILM Wako Pure Chemical Corporation]
Malonic acid [carbon number 3, manufactured by FUJIFILM Wako Pure Chemical Corporation]
Malic acid [carbon number 4, manufactured by FUJIFILM Wako Pure Chemical Corporation]

### (Component D)

Water [pure water of 1 µS/cm or less, produced with a water purification system G-10DSTSET manufactured by ORGANO CORPORATION]

### (Component E)

Diisopropanolamine [manufactured by Mitsui Fine Chemicals, Inc.]
Dibutylaminoethanol [manufactured by NIPPON NYUKAZAI CO., LTD.] (Inorganic acid)
2M sulfuric acid (17%) [manufactured by FUJIFILM Wako Pure Chemical Corporation] *Adjustments were made by diluting the reagent.
35% hydrochloric acid (11.3M) [manufactured by FUJIFILM Wako Pure Chemical Corporation]

The content of the inorganic acid in the table also includes the water content in the sulfuric acid aqueous solution or the hydrochloric acid aqueous solution.

### [Measurement of pH]

The pH of the cleaning agent composition was measured at 25°C with a pH meter (HM-30G, manufactured by TOA Electronics Ltd.), taking a reading 3 minutes after an electrode of the pH meter was immersed in the cleaning agent composition.

### 2. Evaluation of cleaning agent composition

### [Evaluation of oxide film removal speed (discolored metal removal performance)]

Using the cleaning agent compositions of Examples 1 to 33 and Comparative Examples 1 to 5, the oxide film removal speed (discolored metal removal performance) was evaluated in the following manner.

Each of the cleaning agent compositions (Examples 1 to 33 and Comparative Examples 1 to 5) was heated to 60°C and added in an amount of 15 g to 0.3 g of a Cu₂O reagent, and the mixture was irradiated with ultrasonic waves (38 kHz, 600 W) for 6 minutes. This ultrasonic irradiation was a model that simulated ultrasonic cleaning (cleaning time: 6 minutes) of the discolored metal (Cu₂O, oxide film).

Thereafter, the cleaning agent composition was filtered through a 0.45 µm filter, and the amount of metal ions dissolved in the cleaning agent composition (i.e., the amount of dissolved copper ions, ppm) was determined by ICP measurement. Then, the oxide film removal speed was calculated by the following formula. Tables 1-1, 1-2, and 2 show the results. Oxide film removal speed = amount of dissolved copper ions (ppm) / cleaning time (min)

### [Evaluation of damage to iron member]

Using the cleaning agent compositions of Examples 1, 3, 4, 7 to 9, and 31 to 33, damage to Fe members used in an apparatus or a substrate was evaluated in the following manner.

Each of the cleaning agent compositions was heated to 60°C and added in an amount of 50 g to an SPCCB member (20 mm × 50 mm, a steel plate specified in JIS G 3141), and the sample was stored in a thermostatic bath at 60°C for 1 week. This was a model that simulated damage to the member (Fe member) used in the apparatus or the substrate.

After the 1-week storage, the cleaning agent composition was collected and filtered through a 5 µm filter, and the amount of metal ions dissolved in the cleaning agent composition (i.e., the amount of dissolved iron ions, ppm) was determined by ICP measurement. Tables 1-1 and 2 show the results. The cleaning agent compositions of Comparative Examples 1 to 5 were not evaluated for damage because the cleaning speed was slow.

### [Evaluation of flux residue removal performance]

The following cleaning test was performed using a test substrate below to evaluate the flux residue removal performance.

### <Test substrate>

A test substrate was prepared by applying 0.05 g of abietic acid (flux) to a tough pitch copper plate of 50 mm × 20 mm and heating the copper plate on a hot plate at 250°C for 1 hour. The abietic acid was present partially on the surface of the copper plate.

The test substrate thus prepared was a model that simulated the bonding of metals on the substrate based on the heating temperature and the retention time. The test substrate was assumed to be a substrate having flux residue after a sintering process.

### <Cleaning test>

Each of the cleaning agent compositions was heated to 60°C, and subsequently the test substrate was immersed in 100 g of the cleaning agent composition and cleaned using ultrasonic waves at 38 kHz and 400 W for 15 minutes. Then, the test substrate was taken out of the cleaning agent composition, rinsed with water, and dried with air blow, resulting in a cleaned substrate.

### <Flux residue removal rate>

The appearance of the substrate was observed before and after the cleaning, and a flux residue removal rate was calculated by the following formulas.

Flux residue removal rate (%) = area of the substrate from which flux residue was removed after cleaning / area of the substrate to which flux residue was attached before cleaning × 100

Area of the substrate from which flux residue was removed after cleaning = (area of the substrate to which flux residue was attached before cleaning) - (area of the substrate to which flux residue was attached after cleaning)

The results confirmed that all of Examples 1 to 33 and Comparative Examples 1 to 5 achieved a flux residue removal rate close to 100%. Thus, the cleaning agent compositions of Examples 1 to 33 and Comparative Examples 1 to 5 had excellent flux residue removal performance.

**[TABLE 1-1]**

| Table 1-1 | | Example | | | | | | | | |
|---|---|---|---|---|---|---|---|---|---|---|
| | | 1 | 2 | 3 | 4 | 5 | 6 | 7 | 8 | 9 |
| Component A | 2-phenoxyethanol (PHG-S) | 81.5 | 81.5 | 81.5 | 81.5 | 81.5 | 81.5 | 81.5 | 81.5 | 81.5 |
| Component B | 2-methylimidazole | 5 | 5 | 5 | 5 | 5 | 5 | 5 | 5 | 5 |
| Component C | caprylic acid | 3.5 | | | | | | | | |
| | capric acid | | 3.5 | | | | | | | |
| | dodecanedioic acid | | | 3.5 | | | | | | |
| | lauric acid | | | | 3.5 | | | | | |
| | myristic acid | | | | | 3.5 | | | | |
| | palmitic acid | | | | | | 3.5 | | | |
| | oleic acid | | | | | | | 3.5 | | |
| | stearic acid | | | | | | | | 3.5 | |
| | behenic acid | | | | | | | | | 3.5 |
| Component D | water | 10 | 10 | 10 | 10 | 10 | 10 | 10 | 10 | 10 |
| Total (% by mass) | | 100 | 100 | 100 | 100 | 100 | 100 | 100 | 100 | 100 |
| pH | | 8.11 | 8.17 | 7.97 | 8.27 | 8.35 | 8.36 | 8.47 | 8.25 | 8.22 |
| Oxide film removal speed ppm/min | | 245 | 189 | 215 | 184 | 135 | 149 | 146 | 107 | 98 |
| Damage to Fe member ppm | | 7 | - | 1 | 0 | - | - | 0 | 0 | 1 |

**[TABLE 1-2]**

| Table 1-2 | | Example | | | | | | | | | | | | | | | | | | | | | |
|---|---|---|---|---|---|---|---|---|---|---|---|---|---|---|---|---|---|---|---|---|---|---|---|
| | | 1 | 10 | 11 | 12 | 13 | 14 | 15 | 16 | 17 | 18 | 19 | 20 | 21 | 22 | 23 | 24 | 25 | 26 | 27 | 28 | 29 | 30 |
| Component A | 2-phenoxyethanol (PHG-S) | 81.5 | | | 81.5 | 81.5 | 81.5 | | | | | 78.5 | 85.5 | 76.5 | 86.5 | 84.5 | 80 | 76.5 | 76.5 | | | | 75 |
| | benzyl alcohol | | 81.5 | | | | | 81.5 | 81.5 | | | | | | | | | | | | | | |
| | butyl carbinol solvent (BDG) | | | 81.5 | | | | | | 81.5 | 81.5 | | | | | | | | | | | | |
| | DBDG | | | | | | | | | | | | | | | | | | | 81.5 | | | |
| | BFDG | | | | | | | | | | | | | | | | | | | | 81.5 | | |
| | tetrahydrofurfuryl alcohol | | | | | | | | | | | | | | | | | | | | | 81.5 | |
| Component B | 2-methylimidazole | 5 | 5 | 5 | | | | | | | | 8 | 1 | 5 | 5 | 5 | 5 | 5 | 5 | 5 | 5 | 5 | 5 |
| | 2-ethyl-4-methylimidazole | | | | 5 | | | 5 | | 5 | | | | | | | | | | | | | |
| | 1-methylimidazole | | | | | 5 | | | 5 | | 5 | | | | | | | | | | | | |
| | 1-isobutyl-2-methylimidazole | | | | | | 5 | | | | | | | | | | | | | | | | |
| Component E | diisopropanolamine | | | | | | | | | | | | | | | | | 5 | | | | | |
| | dibutylaminoethanol | | | | | | | | | | | | | | | | | | 5 | | | | |
| Component C | caprylic acid | 3.5 | 3.5 | 3.5 | 3.5 | 3.5 | 3.5 | 3.5 | 3.5 | 3.5 | 3.5 | 3.5 | 3.5 | 3.5 | 3.5 | 0.5 | 5 | 3.5 | 3.5 | 3.5 | 3.5 | 3.5 | 10 |
| Component D | Water | 10 | 10 | 10 | 10 | 10 | 10 | 10 | 10 | 10 | 10 | 10 | 10 | 15 | 5 | 10 | 10 | 10 | 10 | 10 | 10 | 10 | 10 |
| Total (% by mass) | | 100 | 100 | 100 | 100 | 100 | 100 | 100 | 100 | 100 | 100 | 100 | 100 | 100 | 100 | 100 | 100 | 100 | 100 | 100 | 100 | 100 | 100 |
| pH | | 8.11 | 8.17 | 7.6 | 8.29 | 7.13 | 7.26 | 8.38 | 7.2 | 7.7 | 7.04 | 8.54 | 6.67 | 8.19 | 8.13 | 8.49 | 7.45 | 9.11 | 8.8 | 8.34 | 7.87 | 7.52 | 6.96 |
| Oxide film removal speed ppm/min | | 245 | 274 | 198 | 323 | 314 | 386 | 299 | 307 | 414 | 361 | 464 | 326 | 260 | 163 | 71 | 250 | 214 | 184 | 105 | 280 | 159 | 221 |

**[TABLE 2]**

| Table 2 | | Example | | | Comparative Example | | | | |
|---|---|---|---|---|---|---|---|---|---|
| | | 31 | 32 | 33 | 1 | 2 | 3 | 4 | 5 |
| Component A | 2-phenoxyethanol (PHG-S) | 81.5 | 81.5 | 81.5 | 85 | 86.5 | 91.5 | 84.59 | 84.3 |
| Component B | 2-methylimidazole | 5 | 5 | 5 | 5 | | 5 | 5 | 5 |
| Component C | lactic acid | 3.5 | | | | | | | |
| | malonic acid | | 3.5 | | | | | | |
| | malic acid | | | 3.5 | | | | | |
| | caprylic acid | | | | | 3.5 | 3.5 | | |
| Inorganic acid | 2M sulfuric acid (17%) | | | | | | | 0.42 | |
| | 35% hydrochloric acid (11.3M) | | | | | | | | 0.70 |
| Component D | water | 10 | 10 | 10 | 10 | 10 | 0 | 10 | 10 |
| Total (% by mass) | | 100 | 100 | 100 | 100 | 100 | 100 | 100 | 100 |
| pH | | 7.3 | 6.57 | 6.71 | 10.8 | 4.06 | 8 | 9.53 | 8.98 |
| Oxide film removal speed ppm/min | | 506 | 373 | 372 | 12 | 11 | 5 | 3 | 18 |
| Damage to Fe member ppm | | 791 | 153 | 980 | | | | | |

As shown in Tables 1-1, 1-2, and 2, the cleaning agent compositions of Examples 1 to 33 are superior to those of Comparative Examples 1 to 5 in the ability to remove the discolored metal (oxide film). All of the cleaning agent compositions of Examples 1 to 33 and Comparative Examples 1 to 5 have excellent flux residue removal performance.

Moreover, the cleaning agent compositions of Examples 1, 3, 4, and 7 to 9, in which the component C is a carboxylic acid having 8 or more carbon atoms, cause less damage to iron members compared to the cleaning agent compositions of Examples 31 to 33, in which the component C is a carboxylic acid having 2 to 4 carbon atoms. The cleaning agent compositions of Examples 2, 5, and 6 are also considered to reduce damage to iron members.

### Industrial Applicability

The use of the cleaning agent composition of the present disclosure can efficiently remove both discolored metal and flux residue. This facilitates, e.g., shortening of the flux cleaning process in the production process of semiconductor apparatuses, and enables high performance and high reliability of the semiconductor apparatuses produced, thereby improving the productivity of the semiconductor apparatuses.

## Claims

1. A cleaning agent composition for removing flux residue, comprising:
at least one organic solvent (component A) selected from the group consisting of a compound represented by the following formula (I) and a compound represented by the following formula (II);
an imidazole compound (component B) represented by the following formula (III);
a carboxylic acid (component C); and
water (component D),
R¹-O-(AO)ₙ-R² (I),
in the formula (I), R¹ represents a phenyl group or an alkyl group having 1 to 8 carbon atoms, R² represents a hydrogen atom or an alkyl group having 1 to 4 carbon atoms, AO represents an ethylene oxide group or a propylene oxide group, and n represents a number of moles of AO added and is an integer of 1 or more and 3 or less,
R³-CH₂OH (II),
in the formula (II), R³ represents a phenyl group, a benzyl group, a cyclohexyl group, a furyl group, a tetrahydrofuryl group, a furfuryl group, or a tetrahydrofurfuryl group, 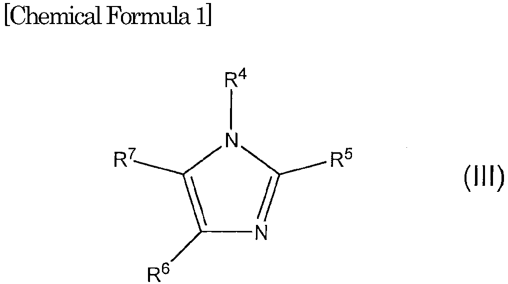
in the formula (III), R⁴, R⁵, R⁶, and R⁷ each independently represent a hydrogen atom, a halogen atom, a methyl group, an ethyl group, a propyl group, an isopropyl group, a butyl group, an isobutyl group, a phenyl group, an aldehyde group, a carboxy group, an aminoethyl group, an aminopropyl group, an acetyl group, a hydroxyethyl group, or a hydroxypropyl group.

2. The cleaning agent composition according to claim 1, wherein a content of the component A is 10% by mass or more and 90% by mass or less.

3. The cleaning agent composition according to claim 1 or 2, wherein a content of the component B is 0.5% by mass or more and 15% by mass or less.

4. The cleaning agent composition according to any one of claims 1 to 3, wherein the component B is at least one selected from the group consisting of imidazole, 1-methylimidazole, 1-ethylimidazole, 1-propylimidazole, 1-isopropylimidazole, 1-acetylimidazole, 1-aminopropylimidazole, 1-hydroxyethylimidazole, 2-methylimidazole, 2-ethylimidazole, 2-propylimidazole, 2-isopropylimidazole, 2-acetylimidazole, 2-aminopropylimidazole, 2-hydroxyethylimidazole, 4-methylimidazole, 4-ethylimidazole, 4-propylimidazole, 4-isopropylimidazole, 4-acetylimidazole, 4-aminopropylimidazole, 4-hydroxyethylimidazole, 1,2-dimethylimidazole, 1-isobutyl-2-methylimidazole, and 2-ethyl-4-methylimidazole.

5. The cleaning agent composition according to any one of claims 1 to 4, wherein a content of the component C is 0.5% by mass or more and 10% by mass or less.

6. The cleaning agent composition according to any one of claims 1 to 5, wherein a mass ratio (C/A) of the component C to the component A is 0.0001 or more.

7. The cleaning agent composition according to any one of claims 1 to 6, wherein a mass ratio (B/A) of the component B to the component A is 0.005 or more and 1.0 or less.

8. The cleaning agent composition according to any one of claims 1 to 7, wherein a mass ratio (B/C) of the component B to the component C is 0.01 or more and 25 or less.

9. The cleaning agent composition according to any one of claims 1 to 8, wherein a content of the component D is 0.5% by mass or more and 20% by mass or less.

10. The cleaning agent composition according to any one of claims 1 to 9, wherein the component C is a carboxylic acid having 8 or more carbon atoms.

11. A cleaning method comprising: a cleaning process of cleaning a workpiece having flux residue with the cleaning agent composition according to any one of claims 1 to 10,
wherein the workpiece is a substrate that has undergone a heating process at 200°C or more.

12. The cleaning method according to claim 11, wherein the workpiece has a metal member containing copper on the substrate.

13. The cleaning method according to claim 12, wherein the substrate surface and/or the metal member of the workpiece includes a portion in which the metal has been oxidized.
